(19) Europäisches Patentamt
European Patent Office
Office européen des brevets

(11) EP 4 585 716 A1

(12) EUROPEAN PATENT APPLICATION

(43) Date of publication:
16.07.2025 Bulletin 2025/29

(51) International Patent Classification (IPC):
C23C 16/455 (2006.01)

(21) Application number: 24213483.1

(22) Date of filing: 18.11.2024

(52) Cooperative Patent Classification (CPC):
C23C 16/45555; A61J 1/1468; C23C 16/403;
C23C 16/405; C23C 16/45529

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 14.12.2023 FI 20236372

(71) Applicant: Picosun Oy
02150 Espoo (FI)

(72) Inventors:
• MANNINEN, Ilkka
  02150 Espoo (FI)
• HIRSJÄRVI, Samuli
  02150 Espoo (FI)

(74) Representative: Heinonen & Co
Attorneys-at-Law Ltd
Fabianinkatu 29 B
00100 Helsinki (FI)

(54) **PHOTOPROTECTIVE COATING FILMS AND METHODS FOR MANUFACTURING THEREOF**

(57) The disclosure concerns a coating film, a method of selecting the coating film for deposition on packaging items configured to contain light-sensitive substances, and a method of manufacturing the coating film. The film is deposited by a process of Atomic Layer Deposition (ALD) on at least one surface of a substrate, preferably configured as a receptacle- and/or packaging item adapted to contain a light-sensitive substance, such as a pharmaceutical compound and/or a medical pre-paration. The coating film comprises one or more layers configured to absorb and/or reflect wavelength(s) of light incident on the coated surface, thereby preventing said wavelength(s) of light from deteriorating light-sensitive contents of the receptacle- and/or packaging item. Thickness of the coating film is determined based on a refractive index of its deposition material, at a predetermined wavelength.

Figure 2

**Description**

FIELD OF THE INVENTION

The present invention generally relates to production of thin films with optical management function by chemical deposition methods. In particular, the invention concerns manufacturing, preferably by Atomic Layer Deposition, of photoprotective coatings on labware, medical packages and/or microfluidic devices.

BACKGROUND OF THE INVENTION

Many pharmaceuticals including, but not limited to cardiovascular drugs, antibiotics, anti-inflammatory and antivirals, are sensitive to various wavelengths of light, in particular, to that within ultraviolet (UV) region of electromagnetic spectrum. When exposed to light rays at a predetermined wavelength or a range of wavelengths, photosensitive pharmaceuticals and/or other bioactive compounds undergo modifications in their chemical structure which impacts the drug's intended therapeutic function and potentially compromises its efficacy, safety, and stability. Additionally, degradation products formed during light-induced conversion of photosensitive drug substances, may introduce new, potentially harmful effects, impacting patient safety.

To protect light-sensitive (e.g. UV-sensitive) drugs and medical preparations from photodegradation, typical solutions include special packaging, storage conditions and/or admixing UV stabilizers into drug formulations. Since modifying chemical formulations is not always possible, and dark storage conditions are sometimes difficult to fulfill, providing light-protecting packaging remains one of the most widely used options to prevent light from deteriorating the contents of the package. Packaging materials that block light of certain wavelengths, typically UV, include amber or dark-colored glass, opaque plastic containers, and/or metallic foils. However, these packaging materials are non-transparent, dark or opaque, which hinders visual inspection of the contents of the package. Additionally, although glass is a traditional choice in pharmaceutical packaging industry due to its inertness towards other substances, not all glass compositions can be altered to block UV-rays without adverse effects. For example, incorporation of UV-absorptive components into glass may have negative impact on its other critical properties, such as mechanical stability of glass and its compatibility with stored components.

Atomic Layer Deposition (ALD) is a technique of deposition of thin films in vapour phase which is extensively described in the art. ALD technology, generally regarded as a subclass of Chemical Vapour Deposition (CVD) processes, has proved an efficient tool for manufacturing high-quality conformal coatings on a variety of three-dimensional substrate structures.

ALD is based on alternating self-saturative surface reactions, wherein different reactants (precursors) provided as molecular compounds or elements in a nonreactive (inert) gaseous carrier are sequentially pulsed into a reaction space accommodating a substrate. ALD films typically include metal oxides, elemental metals, metal nitrides, metal sulfides, where metal halides, metal alkylamides and water, for example, are used as ALD precursors to deposit these films. These films, may be deposited on a nano-scale on complex shaped substrates with excellent large area uniformity and extremely high precision control.

In this regard, prospects of application of ALD techniques in the field of manufacturing items for enclosing and/or storing light-sensitive pharmaceutical substances should further be investigated.

SUMMARY OF THE INVENTION

An objective of the present invention is to solve or to at least alleviate each of the problems arising from the limitations and disadvantages of the related art. The objective is achieved by various embodiments of a coating film and a method of manufacturing the same. In an aspect, a coating film is provided according to what is defined in independent claim 1.

In an embodiment, the coating film is deposited by a process of ALD on at least one surface of a substrate configured to contain a light-sensitive substance, said coating film comprises one or more deposition or coating layers configured to absorb and/or reflect one or more wavelengths of light incident on the coated surface, thereby preventing said wavelength(s) of light from deteriorating light-sensitive contents of the substrate, and said coating film has a thickness determined based on a refractive index of a material said layer or layers is/are composed of, at a predetermined wavelength of incident light.

In an embodiment, the coating film is configured as a single-material structure having same composition across the entire coating depth (thickness).

In another embodiment, the coating film is provided as a laminate structure and comprises one or more layers composed of a first material and one or more layers composed of a second material, wherein the first material differs from the second material at least in terms of its refractive index at a predetermined wavelength of incident light. In an embodiment, in said coating film, the layers composed of the first material alternate with the layers composed of the second material.

In an embodiment, each layer in the coating film provided as a laminate structure has a thickness determined based on a refractive index of a material said layer is composed of, at a predetermined wavelength of incident light.

In an embodiment, the coating film is configured to absorb and/or to reflect light at a UV wavelength ranging from about 100 nm to about 400 nm. In embodiments, the coating film is configured to absorb and/or to reflect light at a UV wavelength selected from any one of: a UVA wavelength ranging from about 315 nm to about 400 nm, a UVB wavelength ranging from about 280 nm to about 315 nm, and UVC wavelength ranging from about 100 nm to about 280 nm. In an embodiment, the coating film is configured to absorb and/or to reflect light at a visible (VIS) wavelength ranging from about 380 nm to about 780 nm.

In embodiments, the coating film comprises one or more layers composed of any one of: aluminium(III) oxide ($Al_2O_3$), titanium(IV) oxide ($TiO_2$), hafnium(IV) oxide ($HfO_2$), zirconium(IV) oxide ($ZrO_2$), zinc oxide (ZnO), tantalum(V) oxide ($Ta_2O_5$), and silicon dioxide ($SiO_2$), and combinations thereof.

In an embodiment, the coating film comprises alternating layers of aluminium(III) oxide ($Al_2O_3$) and of titanium(IV) oxide ($TiO_2$). In other embodiments, the coating film comprises alternating layers of (*i*) titanium(IV) oxide ($TiO_2$) and silicon dioxide ($SiO_2$), and (*ii*) alternating layers of aluminium(III) oxide ($Al_2O_3$) and tantalum(V) oxide ($Ta_2O_5$).

In an embodiment, the coating film has a thickness within a range of about 20 nm to about 300 nm, preferably, within a range of about 50 nm to about 150 nm.

In an embodiment, the coating film is configured to provide see-through visibility with a human eye, when deposited on essentially transparent, see-through surfaces.

In an embodiment, the coating film is deposited on at least one surface of the substrate configured as a receptacle- and/or packaging item.

In an aspect, a method of depositing a coating film on a receptacle- and/or packaging item configured to contain a light-sensitive substance is provided, according to what is defined in independent claim 10.

In a further aspect, a method of selecting a coating film for deposition on a receptacle- and/or packaging item configured to contain a light-sensitive substance is provided according to what is defined in independent claim 15.

In still further aspect, a receptacle- and/or packaging item comprising, on at least one surface thereof, a coating film as defined in some previous aspect and embodiments and/or deposited with a method defined in some previous aspect and embodiments, or selected according to the method defined in some previous aspect and embodiment, according to what is defined in independent claim 17.

The utility of the present invention arises from a variety of reasons depending on each particular embodiment thereof.

Deposition layers deposited by ALD methods are pinhole-free and fully conformal, therefore, the ALD technology has a high potential in manufacturing of high-quality coatings required for various applications, in particular, medical applications. Due to relatively low temperatures utilized during ALD depositions (about 50 °C and above), the coatings can be conformally deposited also on sensitive substrate materials. Hence, the coatings disclosed herewith are applicable to a large range of substrates including, but not limited to packaging items (e.g. containers, vials, syringes, etc.) made of glass and/or plastic; medical preparations, lab-on-a-chip and other microfluidic devices; closures and other parts for the above mentioned devices. The (nano)laminate coating is particularly suitable for use in medical segment, such as for biopharmaceuticals packaging, to serve as a protective, non-toxic and long-lasting medical coating solution.

ALD provides a superior capability to coat any kind of complex three-dimensional structures, including porous structures, through its inherent conformality. Hence, the technology allows for applying light-protective encapsulation also on medical preparations, e.g. pills, tablets or capsules.

Additionally, ALD coatings are typically provided in a nanometer scale, hence, they cause minimal dimensional change to the substrate.

The photoprotective coating films disclosed herewith are transparent and hence enable unhindered see-through visibility with a human eye. This facilitates visual inspection of a drug provided in a glass or plastic vial for example, and allows for immediate detection of precipitate and/or impurities in the vial, thus enhancing the patient's safety. The term "patient" is used herein to describe any human or non-human animal subject, and the like.

Nanolaminate structures disclosed herewith enable constructing light-protective coatings configured to prevent transmission of various wavelengths therethrough. For example, some selected layer(s) in the proposed coating films may be configured to manage visible light, while some other layers may be configured to manage selected wavelengths within the UV-region. By combining different deposition materials, by adjusting layer thickness and composition, and/or by controlling deposition process conditions (e.g. temperature), the presently disclosed coating films can be rendered with desired photoabsorptive and/or reflective functionalities. Along with the photoabsorptive and/or reflective property/-ies the resulted coatings are additionally rendered with a higher chemical resistance.

In the present disclosure, materials with a layer thickness below 1 micrometer ($\mu$m) are referred to as "thin films".

The terms "substrate" or "item" are used in the present disclosure to indicate a physical object which is intended to undergo coating by the methods disclosed herewith. The substrate may thus be any suitable item before coating.

The terms "stack" or "laminate structure" are used in the present disclosure to indicate a layered structure, which comprises two or more layers arranged on top of one another. The stack comprises layers deposited with chemical deposition methods, including ALD, it's analogues and modifications (such as for example plasma enhanced- or photon enhanced ALD), and in some instances, MLD, unless explicitly indicated otherwise.

The terms "coating", "coating film" and "film" are intended, within the present disclosure, to have the same meaning, namely, to define a layer or layers of a substance that covers a surface of a substrate. Unless explicitly stated otherwise, these terms are used, in the present disclosure, to refer to a final coating deposited on the substrate and imparted with all desired/required functionalities. Substrate or item having "coating" or "coating film" or "film" deposited thereon is referred to as a "coated substrate" or a "coated item", respectively.

The expressions "reactive fluid" and "precursor fluids" are indicative in the present disclosure of a fluidic flow comprising at least one chemical compound (a precursor compound), hereafter, a precursor, in an inert carrier. In some instances, precursor fluid contains a precursor compound co-dosed with another precursor compound in inert gas carrier. The expression "set of precursors" relates to two or more precursor compounds used to deposit an individual material (deposition) layer.

The expression "a number of" refers herein to any positive integer starting from one (1), e.g. to one, two, or three; whereas the expression "a plurality of" refers herein to any positive integer starting from two (2), e.g. to two, three, or four.

The terms "first" and "second" are not intended to denote any order, quantity, or importance, but rather are used to merely distinguish one element from another, unless explicitly stated otherwise.

BRIEF DESCRIPTION OF THE DRAWINGS

Figs. 1A-1C schematically illustrate a coating film 10, according to the embodiments, on a substrate 20.

Figs. 2 is a schematic illustration of an optical function of the coating film 10 relative to incident light.

Figs. 3A and 3B show transmission results for the coating film structures, according to the embodiments.

Fig. 4 shows an exemplary receptacle- and/or packaging item (configured as a glass vial) coated with the coating film according to the embodiments compared to conventional (uncoated) items.

DETAILED DESCRIPTION OF THE EMBODIMENTS

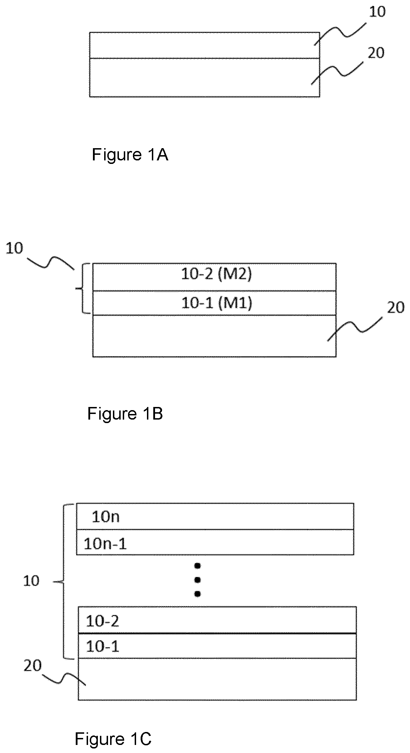

Figs. 1A, 1B and 1C illustrate a coating film 10 implemented according to the embodiments and rendered with photoabsorptive and/or reflective functionality relative to selected wavelengths of incident light.

The coating film 10 is designed to be deposited on a substrate 20. The substrate 20 is advantageously configured to enclose and/or store light-sensitive contents. The term "light-sensitive contents" is referred to, in the context of present disclosure, to any compound or substance that deteriorates, i.e. undergoes modifications that result in physical degradation of the compound/substance and/or in reduction or loss of its activity/function (e.g. pharmaceutical or biological activity/function), upon being exposed to light. Such light-sensitive contents include pharmaceutical compounds, bioactive substances, various biological and/or chemical substances, polymers, and the like. Light-sensitive substance can be provided in essentially liquid, gel-like, or solid forms, wherein liquids include solutions or suspensions of any appropriate consistency, and solids include any one of powders or pressed preparations (e.g. pressed pills).

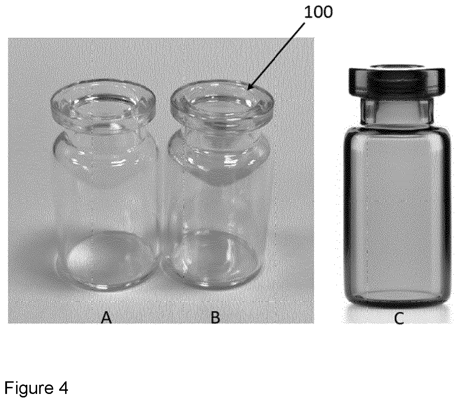

In an embodiment, the substrate 20 is configured as a receptacle- and/or packaging item configured to enclose and/or store said light-sensitive contents. Exemplary receptacle- and/or packaging items include vials, containers, bottles, flasks, ampules, sample tubes, cuvettes, pipettes and pipet tips, syringes, blister packs, as well as microfluidic devices, such as flow cells. In some embodiments, the receptacle- and/or packaging item is configured as a medical package. In some embodiments, the medical package is a primary package having its interior brought into direct contact with the contents of the package (i.e. a vial including light-sensitive liquid). Exemplary receptacle- and/or packaging item 100 provided as a coated glass vial is shown on Fig. 4B.

The coating film 10 is advantageously applied onto at least one surface of the substrate, configured, in an embodiment, as a receptacle- and/or packaging item. The coated surface may be an inner surface, an outer surface or both inner and outer surfaces of the coated item. Hence, the coating film 10 can be applied to any selected surface of the item, or onto all surfaces thereof. For example, the surface or surfaces of the receptacle- and/or packaging item deposited or intended for deposition with the coating film 10 are further collectively referred to as a substrate, and designed on Figs. 1A-1C with reference numeral 20.

The coating film 10 described herewith is designed to prevent electromagnetic radiation of certain wavelengths from reaching the light-sensitive contents of the substrate (configured, in an embodiment, as a receptacle- and/or packaging item). The coating film 10 thus prevents, fully or partly, transmission of certain wavelengths of light harmful to the contents of the receptacle/package. It is preferred, that the coating film 10 is configured to selectively block wavelengths or ranges of wavelengths that cause deterioration of the substance inside the coated item, but to allow the harmless radiation to penetrate the coated surface(s).

Selective transmission is enabled with rendering the coating film with at least one light management function related to one or more wavelengths of light incident on the coated surface. The light management function is preferably selected from absorption, reflection, or a combination thereof.

The term "light", is referred to, in the context of the present disclosure, to electromagnetic radiation at wavelength ranges in visible light (VIS) and ultraviolet (UV) regions of the electromagnetic spectrum. Visible light is the portion of the electromagnetic spectrum that human eyes can perceive. It spans wavelengths from about 380 nm to about 780 nm, more typically, from about 400 nm to about 700 nm. A UV-ray is a segment of the electromagnetic spectrum, with a wavelength ranging from about 100 nm to about 400 nm, and is conventionally subdivided into three bands: UVA (about 315 to about 400 nm), UVB (about 280 nm to about 315 nm), and UVC (about 100 nm to about 280 nm).

The coating film 10 comprises one or more coating layers, hereafter, layers. In some configurations the coating film is configured as a uniform structure formed with a single material (see Fig. 1A). Said uniform structure may be formed with one or more coating layers. In some other configurations, the coating layer is configured as a laminate structure comprising a number of layers formed with different materials and arranged atop one another to form a stack. Since the final coating film 10 has a thickness within a range of about 20 nm to about 300 nm, it is referred to as "nanolaminate". On Fig. 1B, nanolaminate stack is formed with two materials, wherein a first deposition layer 10-1 is formed with a first material M1 having a first composition, and a second deposition layer 10-2 (formed on the layer M1) is formed with a second material M2 having a second composition non-identical to the first composition. First deposition layer M1 can be formed directly on the substrate, as shown on Fig. 1B, or, alternatively, a primer deposition layer may be provided between the substrate and the first deposition layer M1 to improve adhesion of the coating film to the substrate (not shown). Fig. 1C shows a multilayer configuration, comprising more than two deposition- or coating layers (10-1, 10-2 ... 10n-1 and 10n). These layers can be arranged into repetitive patterns to form a stack, with each said pattern comprising one (1) to four (4) deposition layers composed of non-identical chemical compounds. In an embodiment, the layers of materials having different composition (M1, M2) have different refractive indices.

Deposition layers are preferably formed on the substrate via a process of ALD.

The basics of an ALD growth mechanism are known to a skilled person. ALD is a chemical gas phase thin film deposition method based on alternate supply of at least two reactive precursor species (in gaseous phase) to a substrate, which forces the film growth reactions to proceed only on the surface in a highly controlled manner. It is to be understood, however, that one of these reactive precursors can be substituted by energy when using, for example, plasma-enhanced ALD (PE-ALD), or photon-enhanced ALD, leading to single precursor ALD processes. Thin films grown by ALD are dense, pinhole free and have uniform thickness.

In ALD, the substrate is typically exposed to temporally separated precursor pulses in a reaction vessel to deposit material on substrate surface or surfaces by sequential self-saturating surface reactions. In the context of present disclosure, the term ALD comprises all applicable ALD-based techniques, as well as, equivalent or closely related technologies, including, but not limited to the following ALD sub-types: plasma-enhance ALD (PE-ALD) also referred to plasma-assisted ALD, and photon-enhanced ALD, also referred to as photo-ALD or flash enhanced ALD.

Deposition setup may be the one based on an ALD installation described in the U.S. patent no. 8211235 (Lindfors), for example, or on any installation, such as Picosun R-200, P-300 or P-1000 ALD system, available from Picosun Oy, Finland. Nevertheless, the features underlying a concept of the present invention can be incorporated into any other chemical deposition reactor generally embodied as a reactor for ALD, PEALD and/or MLD, or as Chemical Vapour Deposition (CVD) device, for example.

An exemplary ALD reactor comprises a reaction chamber that establishes reaction space (deposition space), in which production of (nano)laminate coatings and/or coated items described in the present disclosure takes place. The reactor further comprises a number of appliances configured to mediate fluidic flow (inert fluids and reactive fluids containing precursor compounds P1, P2, see FIG 1) into the reaction chamber. These appliances are provided as a number of intake lines / feedlines and associated switching and/or regulating devices, such as valves, for example.

Substrates to be coated are typically loaded on a substrate holder, which, in turn, is inserted inside the reaction chamber. In order to coat a batch of glass vials in the ALD reactor of the type indicated herein above, the vials may be provided on a substrate holder comprising, as an example, a number of protrusions configured to hold a vial in an upside down position. Such an arrangement advantageously allows for coating the outer surface(s) of the vials. In order to deposit the coating on an inner surface and/or on an entire surface of the vial, precursor gas may be supplied through the substrate holder to reach the interior of all vials positioned thereon (not shown). Alternatively, the substrate holder may be provided in the form of a shelf or basket preferably made of net- or grid material, such as steel grid, for example, in order to enable an unobstructed flow of process gasses therethrough. The substrate holder may be configured to incorporate several shelves or baskets arranged into a vertical rack. Substrate holders of any other configuration may be utilized, depending on substrates to be coated and/or on implementation of a reactor apparatus in which the coating process is conducted (e.g. batch reactor with vertical or horizontal loading, reactor configured for continuous coating, etc.), which configurations may include, but are not limited to horizontal platforms, sample trays, racks of various design, and the like.

A basic ALD deposition cycle consists of four sequential steps: (1) pulse A, (2) purge A, (3) pulse B, and (4) purge B. Reactive fluid entering the reaction chamber during pulses A and B is preferably a gaseous substance comprising a predetermined precursor chemical carried by an inert carrier (gas). Delivery of the precursor chemicals into the reaction space and film growth on the substrate is/are regulated by means of the abovesaid regulating appliances, such as e.g. three-way ALD valves, mass-flow controllers or any other device suitable for this purpose.

Overall, each deposition cycle (Pulse A - Purge A - Pulse B - Purge B) results in formation of 0.05-0.2 nm thick "sub-layer". This sequence is repeated until the desired material thickness is achieved. By way of example, a 20 nm coating film may thus be deposited in 100 or 200 deposition cycles with exemplary growth rate 0.2 nm or 0.1 nm per deposition cycle, respectively.

As indicated above, the coating film 10 may consist of one or more ALD-coating layers 10-1, 10-2, 10n-1, 10n, composed of same or different materials. In some instances, the coating film consists of a single material and hence may be viewed as a film consisting of a single coating layer (see Fig. 1A). In some other instances, as shown on Fig. 1B, the coating film is provided as a laminate structure, comprises at least two coating layers deposited with different materials. For example, a first coating layer composed of a first material M1 and having a first thickness may be produced in a predetermined number of deposition cycles. Thereafter, a second coating layer composed of a second material M2 and having a second thickness may be produced atop the first coating layer in similar manner (see Fig. 1B).

A plurality of ALD-deposition cycles results in the formation of a thin film ("coated film") from a timed deposition sequence, which is controlled by a logic unit or a microprocessor of the related deposition equipment setup. More simple or more complex deposition cycles / deposition sequences can be implemented. For example, deposition cycles can include three or more reactant vapor pulses separated by purging steps, or, alternatively, certain purge steps can be omitted. On the other hand, for example photon-enhanced ALD has a variety of options, such as using only one active precursor in a corresponding precursor set, with various options for purging.

The coating film 10 is preferably selected such as to possess an optimal property of absorption and/or reflection of photons related to one or more wavelengths of light incident on the coated substrate surface, and by virtue of absorbing and/or reflecting - to prevent transmission of said wavelength(s) of light through the substrate. The coating 10 is advantageously designed to block only those wavelengths of light that are harmful to light-sensitive contents of the substrate 20 (the latter configured as a receptacle- and/or packaging item), thereby preventing said wavelengths from deteriorating contents of the package.

A primary ALD coating (uniform coating or nanolaminate stack) may be topped with an additional overcoat layer (not shown) rendered with various functionalities, such as for example resistance to mechanical abrasion and/or corrosion, anti-reflective, and the like.

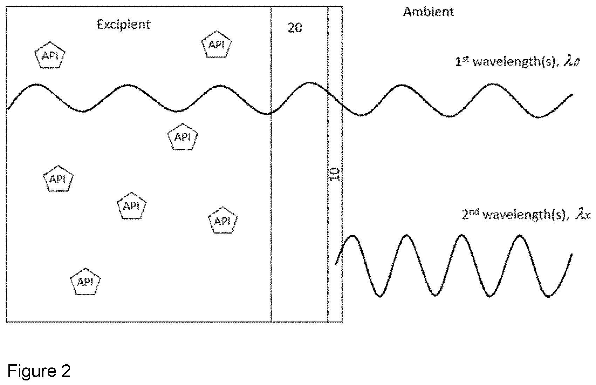

Simplified schematics of light management property of the coating film 10 is shown on Fig. 2. Fig. 2 illustrates a situation, where a substrate 20 configured as a receptacle- and/or packaging item, in particular, a primary package for a pharmaceutical compound- or a medical preparation (designated as "API" (active pharmaceutical ingredient) present in a suitable excipient) is coated with the coating film 10. Fig. 2 shows an exemplary configuration with the coating film 10 deposited on an outer surface of the substrate configured herein as a receptacle. Alternatively, coating film 10 may be deposited in an inner surface of the substrate configured herein as a receptacle (in direct contact with the substance inside the receptacle 20) or on both inner and outer surfaces thereof (not shown). The substrate 20 is exposed to ambient light (natural or artificial (sun)light, for example), naturally composed of various wavelengths that include low energy wavelengths (e.g. those within a visible light (VIS) region of the electromagnetic spectrum) and high energy wavelengths (typically UV-wavelengths). Amongst those, some high energy wavelengths, designated on Fig. 2 with $\lambda_x$ (lambda x) are harmful to the contents of the receptable. On the other hand, the ambient also includes harmless low energy electromagnetic radiation designated on Fig. 2 with $\lambda_0$ (lambda 0). Terms "harmful" and "harmless" are used herewith to indicate that some wavelengths of light can be deteriorating to the substances enclosed and stored in the receptacle- and/or packaging item 20; however, this deteriorating effect may vary substance-wise. It is however noted that a wide variety of common drugs, such as antibiotics, cardiovascular system acting agents, inflammatory drugs, antidiabetics, antipathogenic agents, etc., are known to undergo photochemical degradation when exposed to UV-rays.

The coating 10 described herewith is preferably configured such as to minimize transmission for "harmful" wavelengths $\lambda_x$ through the substrate (item) 20. The coating film 10 may further be configured to allow transmission of wavelengths $\lambda_0$ harmless for a specific substance contained in the receptacle (as illustrated on Fig. 2). Alternatively, the coating film 10 may be designed, along with blocking harmful wavelengths $\lambda_x$, to at least partly block the harmless wavelengths $\lambda_0$ as well (not shown).

Transmission of light rays/ray bands of predetermined wavelengths through the substrate 20 is controlled with any one of absorption and reflection optical function of the coating film 10, or a combination thereof.

In embodiments, the coating film 10 is configured for selective transmission of certain wavelengths of light ($\lambda_0$) therethrough (see, Fig. 2, 1st wavelength(s)). In embodiments, the coating 10 is configured to prevent (through the phenomena of absorption and/or reflection of photons) transmission of selected wavelengths ($\lambda_x$) of light through the coated surface (see. Fig. 2, 2nd wavelength(s)). In a latter case, blocking of second (e.g. harmful) wavelengths is accompanied with transmission of first (typically harmless) wavelengths. Since photosensitivity of different biological/(bio) chemical substances towards certain wavelengths of light may vary; the nature of substance to be protected from e.g. UV-light exposure is taken into account in implementation of the coating film 10.

In the present disclosure, the optical function of the coating film 10 related to (photo)absorption and/or reflection of predetermined wavelength(s) of incident light is controlled by thoroughly selecting materials for depositing the coating film and layers thereof and by adjusting the layer thickness in accordance with refractive indices of these deposition materials at a predetermined wavelength.

During experimental trials underlying the present invention, it has been determined that the coating films 10 comprising the layers of aluminium(III) oxide (alumina, $Al_2O_3$) and titanium(IV) oxide (titania, $TiO_2$) efficiently reduce transmission of the UV-light and also reduce, to some extent, transmission of visible light, through the coated surfaces. Coating films comprising alternating layers of high refractive index materials, such as $TiO_2$, $Ta_2O_5$, $ZrO_2$, $HfO_2$, and low refractive index materials, such as $Al_2O_3$, $SiO_2$, in any combination, can be conceived. By way of example, coating films 10 may be configured as laminate structures including alternating layers of $Al_2O_3$-$TiO_2$, $TiO_2$-$SiO_2$, $Ta_2O_5$-$Al_2O_3$, and the like.

The laminate coating film 10 has been formed comprising alternating layers of alumina and titania on a substrate 20 made of glass and/or polymers including plastics. In some examples, glass was borosilicate glass and plastic was Cyclic Olefin Polymer (COP). Some other exemplary substrates include Cyclic Olefin Copolymers (COC) and an organic/inorganic hybrid polymer polydimethylsiloxane (PDMS). Amongst those, borosilicate glass is the standard glass for primary packaging of pharmaceutical compounds, while COP, and (COC), represent novel, but rapidly emerging types of plastic materials for primary packaging.

Thickness of the coating film and/or the individual layers constituting the coating film were advantageously determined based on a refractive index of a material said layer or layers is/are composed of, at a predetermined wavelength of incident light.

Bragg mirror type structures were hence created with the coating layers of alumina and titania, with their layer thicknesses determined based on a (harmful) wavelength ($\lambda$) of incident light, whose transmission through the coated substrate is to be prevented/minimized. Bragg mirror or Bragg reflector typically consists of a multilayer structure, in which layers of materials having high refractive index ($n_{high}$) alternative with the layers of materials having low refractive index ($n_{low}$). For example, at a selected wavelength of 350 nm (UV-A range), the refractive index of titania ($n\_TiO_2$) is 3.06, and the refractive index of alumina ($n\_Al_2O_3$) is 1.64. The refractive indices were obtained from a conventional ellipsometer device. Thickness of the coating layer or layers to be deposited with titania and alumina was deposited based on an equation (1):

$$(1) \qquad t = \lambda /(4*n)$$

wherein t is a layer thickness, $\lambda$ (lambda) is the identified wavelength, and $n$ is a refractive index of the layer material.

The layer thicknesses for $Al_2O_3$ and $TiO_2$ layers were thus calculated as follows:

$$t(Al_2O_3) = lambda/(4*n\_Al_2O_3) = 350 \text{ nm}/(4*1.64) = 53 \text{ nm}$$

$$t(TiO_2) = lambda/(4*n\_TiO_2) = 350 \text{ nm}/(4*3.06) = 29 \text{ nm}$$

The substrate 20 was hence deposited with the coating film 10 comprising the 53 nm $Al_2O_3$ coating layer (10-1, M1) and the 29 nm $TiO_2$ coating layer 10-2 (M2), as shown on Fig. 10B. With increasing the number of dyads (i.e. combinations of layers made of two different materials, e.g. of $Al_2O_3$ and $TiO_2$) the reflectance of the coating film 10 can be increased. The difference between the refractive indices increases the reflectance as well. In present example, $TiO_2$ represents the medium with high refractive index ($n_{high}$), and $Al_2O_3$ - medium with low refractive index ($n_{low}$).

Hence, the present invention further pertains to a method for selecting a coating film for deposition on a substrate preferably configured as a receptacle- and/or packaging item that contains a light-sensitive substance, the method comprising the steps of:

(i) identifying one or more wavelengths ($\lambda$, lambda) of light to be prevented from reaching the light-sensitive contents of the receptacle- and/or packaging item;

(ii) identifying at least one material with a property of absorption and/or reflection related to one or more wavelengths identified at step (i);

(iii) measuring refractive index of the material identified at step (ii), and

(iv) determining a thickness of a coating layer or layers to be deposited with the at least one material identified at step (ii) based on equation:

$$t = \lambda /(4*n)$$

wherein $t$ is a layer thickness, $\lambda$ (lambda) is a wavelength identified at step (i), and $n$ is a refractive index of the material identified at step (ii).

In some instances, the method comprises identifying, at step (ii), a first material and a second material, wherein diffractive index of the first material is different from refractive index of the second material at the wavelength of incident light identified at step (i).

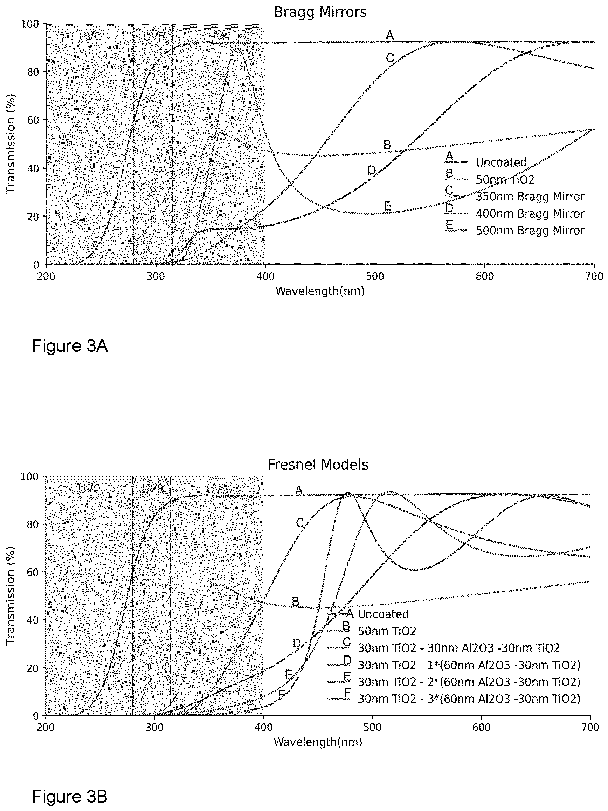

Fig. 3A shows transmission results for three different coating film structures composed of $Al_2O_3$ (low refractive index material) and $TiO_2$ (high refractive index material) as described above and generally known as "Bragg mirrors". These laminate coatings were specifically designed for reflecting three different wavelengths of light (350 nm, 400 nm and 500 nm). Transmission of light through these coatings is limited due to two phenomena occurring in the laminate structures: absorption at wavelengths essentially below 350 nm occurring in $TiO_2$ and reflection of the wavelengths essentially above 350 nm by the Bragg mirror. By way of example, the coating film designed as a 500 nm Bragg Mirror (E, Fig. 3A) demonstrates a clear local minimum at a wavelength of 500 nm with transmission of approximately 20%. Increasing the number of layers in the stack (e.g. increasing the number of dyads as mentioned hereinabove) will reduce the transmission down to essentially 0%.

Fig. 3B shows a graph designated "Fresnel Models" for a number of laminate structures provided as follows:

50 nm $TiO_2$ (B);
30 nm $TiO_2$ - 30 nm $Al_2O_3$ - 30 nm $TiO_2$ (C);
30 nm $TiO_2$ - 1*(60 nm $Al_2O_3$ - 30 nm $TiO_2$) (D);
30 nm $TiO_2$ - 2*(60 nm $Al_2O_3$ - 30 nm $TiO_2$) (E);
30 nm $TiO_2$ - 3*(60 nm $Al_2O_3$ - 30 nm $TiO_2$) (F).

Line A illustrates transmission through uncoated substrate (glass or plastic).

Alternatively, or in addition to $Al_2O_3$-$TiO_2$ stacks, the coating film 10 implemented as a Bragg mirror type structure can further include any combination of materials with high refractive index ($n_{high}$), such as tantalum(V) oxide ($Ta_2O_5$), zirconium(IV) oxide ($ZrO_2$), hafnium(IV) oxide ($HfO_2$), and materials with low refractive index ($n_{low}$), such as silicon dioxide ($SiO_2$). Coating films 10 configured as laminate structures including alternating layers of $Al_2O_3$-$TiO_2$, $TiO_2$-$SiO_2$, $Ta_2O_5$-$Al_2O_3$, and the like, can be realized.

It is further noted that multilayer laminate coatings 10 alternating $n_{high}$ and $n_{low}$ deposition layers are not limited to repeating dyad patterns (i.e. alternating layers of 1st material and 2nd material), but may further include alternating patterns of three (3) or four (4) materials while preserving the Bragg mirror structure.

Overall, it has been shown the coating film 10 demonstrates similar results on both glass and plastic substrates. It has been shown that transmission of the UV-wavelengths and, at least, a part of visible light wavelengths can be effectively minimized with the coating film 10 comprising the $TiO_2$ layer or layers having a total thickness of at least 20 nm, and, preferably, within a range of about 20 nm to about 100 nm, still preferably, within a range of about 20 nm to about 50 nm. It is noted that a total thickness of some material layer may be achieved by summing up the thicknesses of all layers made of this material in the laminate structure. For example, in the laminate structure comprising two 30 nm layers of $TiO_2$ alternating with, for example, $Al_2O_3$, the total thickness of titania layers will be about 60 nm.

Laminate nanolayers were deposited through ALD using trimethylaluminium (TMA) and $H_2O$ precursors to deposit $Al_2O_3$ layers and titanium tetrachloride ($TiCl_4$) and $H_2O$ precursors to deposit $TiO_2$ layers. Overall, deposition of 20-300 nm laminate coatings proceeded at deposition temperatures within a range of about 80 °C to about 200 °C or about 250 °C. Deposition within a range of about 50 to about 125 °C enables or facilitates formation of coatings on heat-sensitive substrates, such as those containing heat-degradable biological substances, polymers and/or electric circuits.

Alternatively, or in addition to the layers of $TiO_2$ and/or $Al_2O_3$ described hereinabove, the coating film 10 can further comprise one or more layers composed of any one of: hafnium(IV) oxide ($HfO_2$), zirconium(IV) oxide ($ZrO_2$), zinc oxide (ZnO), tantalum(V) oxide ($Ta_2O_5$), and silicon dioxide ($SiO_2$), provided as a single compound, or any combination of compounds taken that by virtue of said combination the above described Bragg mirror effect is achieved and maintained. Utilization of any other appropriate materials is not excluded.

In embodiments, the coating film 10 is configured to provide see-through visibility with a human eye, when deposited on essentially transparent, see-through surfaces. Hence, the coating film 10 deposited on essentially transparent, see-through glass (clear or colored, such as borosilicate glass, for example), does not hinder transparency of the (uncoated) glass substrate and/or visibility therethrough with the human eye.

Fig. 4 shows different glass vials, where (A) is a clear (fully transparent) uncoated glass vial; (B) is the glass vial (same as in A) coated with the coating film 10 (coating thickness 100 nm); and (C) is a vial made of amber glass. When deposited on a surface of a clear (fully transparent) glass vial, the coating film 10 is almost fully invisible except demonstrating, in some instances, a minor sheen at the vial surface, which could be also completely eliminated by modifying the coating thickness. However, the glass vial coated with the coating film 10 (Fig. 4, B) is clearly far more transparent than, for example, the amber vial (Fig. 4, C), making the visual inspection easier.

The present invention further pertains to a method of depositing a coating film 10 on a substrate preferably configured as a receptacle- and/or packaging item 100 that contains a light-sensitive substance, wherein the coating film produced herewith comprises one or more layers configured to absorb and/or to reflect one or more wavelengths of light incident on a coated surface thereby preventing said wavelength(s) of light from deteriorating the light-sensitive contents of the receptacle- and/or packaging item. The method comprises at least the following steps:

(i) obtaining a receptacle- and/or packaging item; and
(ii) on at least one surface of said receptacle- and/or packaging item depositing a coating film by a process of Atomic Layer Deposition (ALD),

wherein, thickness of the coating film is determined based on a refractive index of a material the layer or layers of the coating film is/are composed of, at a predetermined wavelength of incident light.

The coating method is applicable for deposition the coating film 10 on a surface or surfaces of any receptacle- and/or packaging item made of glass and/or plastic and including, but not limited any one of: vials, containers, bottles, flasks, ampules, sample tubes, cuvettes, pipettes, pipet tips, syringes, microfluidic devices, well devices, such as well plates utilized in a variety of *in vitro* cell experiments, for example, as well as closures and other parts related to the above mentioned items.

The present invention further pertains to receptacle- and/or packaging item 100, comprising the coating film according to the embodiments. The item 100 is preferably made of glass and/or plastic, and configured to enclose and store substances in liquid form, in gel-like form or in solid form, including preparations pressed into shape, particulates and powders.

In embodiments, the receptacle- and/or packaging item 100 is configured as a medical package to enclose and store pharmaceuticals and medicine preparations. Overall, the item 100 may be configured as any one of: a vial, a container, a bottle, a flask, an ampule, a sample tube, a cuvette, a pipette, a pipet tip, a syringe, a microfluidic device, a well device, such as a well plate, as well as related closures and other parts.

It shall be appreciated by those skilled in the art that with the advancement of technology the basic ideas of the present invention may be implemented and combined in various ways. The invention and its embodiments are thus not limited to the examples described hereinabove, instead they may generally vary within the scope of the claims.

**Claims**

1. A coating film deposited by a process of Atomic Layer Deposition (ALD) on at least one surface of a receptacle- and/or packaging item configured to contain a light-sensitive substance, the coating film comprising one or more layers configured to absorb and/or reflect one or more wavelengths of light incident on the coated surface, thereby preventing said wavelength(s) of light from deteriorating light-sensitive contents of the receptacle- and/or packaging item, wherein the coating film has a thickness determined based on a refractive index of a material said layer or layers is/are composed of, at a predetermined wavelength of incident light, and wherein the receptacle- and/or packaging item is configured as a medical package to enclose and store light-sensitive pharmaceuticals and medicine preparations, said receptacle- and/or packaging item being made of glass and/or polymer including a plastic.

2. The coating film of claim 1 configured as a laminate structure and comprising one or more layers composed of a first material and one or more layers composed of a second material, wherein the first material differs from the second material at least in terms of its refractive index at a predetermined wavelength of incident light, and wherein the layers composed of the first material alternate with the layers composed of the second material.

3. The coating film of claim 2, wherein each layer in the laminate structure has a determined thickness based on a refractive index of a material said layer is composed of, at a predetermined wavelength of incident light.

4. The coating film of any preceding claim, configured to absorb and/or to reflect light at a UV wavelength ranging from about 100 nm to about 400 nm, said UV wavelength selected from any one of: a UVA wavelength ranging from about 315 nm to about 400 nm, a UVB wavelength ranging from about 280 nm to about 315 nm, and UVC wavelength ranging from about 100 nm to about 280 nm.

5. The coating film of any preceding claim, configured to absorb and/or to reflect light at a visible (VIS) wavelength ranging from about 380 nm to about 780 nm.

6. The coating film of any preceding claim, comprising one or more layers composed of any one of: aluminium(III) oxide ($Al_2O_3$), titanium(IV) oxide ($TiO_2$), hafnium(IV) oxide ($HfO_2$), zirconium(IV) oxide ($ZrO_2$), zinc oxide (ZnO), tantalum(V) oxide ($Ta_2O_5$), silicon dioxide ($SiO_2$), and combinations thereof.

7. The coating film of any preceding claim 2-6, comprising alternating layers of aluminium(III) oxide ($Al_2O_3$) and titanium(IV) oxide ($TiO_2$).

8. The coating film of any preceding claim, having a thickness within a range of about 20 nm to about 300 nm, preferably, within a range of about 50 nm to about 150 nm.

9. The coating film of any preceding claim, configured to provide see-through visibility with a human eye, when deposited on essentially transparent, see-through surfaces.

10. A method of depositing a coating film on a receptacle- and/or packaging item configured to contain a light-sensitive substance, said coating film comprising one or more layers configured to absorb and/or to reflect one or more wavelengths of light incident on a coated surface thereby preventing said wavelength(s) of light from deteriorating the light-sensitive contents of the receptacle- and/or packaging item, the method comprising:

   (i) obtaining a receptacle- and/or packaging item; and
   (ii) on at least one surface of said receptacle- and/or packaging item depositing a coating film by a process of Atomic Layer Deposition (ALD),
   wherein thickness of the coating film is determined based on a refractive index of a material the layer or layers of the coating film is/are composed of, at a predetermined wavelength of incident light, and
   wherein the receptacle- and/or packaging item is configured as a medical package to enclose and store light-sensitive pharmaceuticals and medicine preparations and selected from any one of: a vial, a container, a bottle, a flask, an ampule, a sample tube, a cuvette, a pipette, a pipet tip, a syringe, a well plate, and the like, said receptacle- and/or packaging item being made of glass and/or polymer including a plastic.

11. The method of claim 10, comprising depositing, by a process of Atomic Layer Deposition (ALD), one or more layers composed of a first material and one or more layers composed of a second material to produce the coating film, wherein the first material has different refractive index than the second material, at a predetermined wavelength of incident light, and wherein the layers composed of the first material and the layers composed of the second material are deposited in an alternating manner.

12. The method of any one of claims 10 or 11, comprising producing the coating film by depositing, via ALD, one or more layers composed of any one of: aluminium(III) oxide ($Al_2O_3$), titanium(IV) oxide ($TiO_2$), hafnium(IV) oxide ($HfO_2$), zirconium(IV) oxide ($ZrO_2$), zinc oxide (ZnO), tantalum(V) oxide ($Ta_2O_5$), silicon dioxide ($SiO_2$), and combinations thereof.

13. The method of any preceding claim 10-12, comprising producing the coating film by depositing, via ALD, alternating layers of aluminium(III) oxide ($Al_2O_3$) and titanium(IV) oxide ($TiO_2$).

14. The method of any preceding claim 10-13, wherein the coating film is deposited on an inner surface-, an outer surface-, or both inner and outer surfaces of the receptacle- and/or packaging item.

15. A method of selecting a coating film for deposition on a receptacle- and/or packaging item configured to contain a light-sensitive substance, the method comprising the steps of:

   (i) identifying one or more wavelengths ($\lambda$, lambda) of incident light to be prevented from reaching the light-sensitive contents of the receptacle- and/or packaging item;

(ii) identifying at least one material with a property of absorption and/or reflection related to one or more wavelengths identified at step (i);

(iii) measuring refractive index of the material identified at step (ii), and

(iv) determining a thickness of a coating layer or layers to be deposited with the at least one material identified at step (ii) based on equation:

$$t = \lambda /(4^*n)$$

wherein t is a layer thickness, $\lambda$ (lambda) is a wavelength identified at step (i), and $n$ is a refractive index of the material identified at step (ii),

wherein the receptacle- and/or packaging item is configured as a medical package to enclose and store light-sensitive pharmaceuticals and medicine preparations and selected from any one of: a vial, a container, a bottle, a flask, an ampule, a sample tube, a cuvette, a pipette, a pipet tip, a syringe, a well plate, and the like, said receptacle- and/or packaging item being made of glass and/or polymer including a plastic.

16. The method of claim 15, further comprising identifying, at step (ii), a first material and a second material, wherein the diffractive index of the first material is different from the refractive index of the second material at the wavelength of incident light identified at step (i).

17. A receptacle- and/or packaging item made of glass and/or polymer, including a plastic and comprising, on at least one surface thereof, a coating film as defined in any one of claims 1-9 and/or deposited with a method defined in any one of claims 10-14 or selected according to the method of any one of claims 15 or 16.

18. The receptacle- and/or packaging item of claim 17 configured to enclose and store substances in liquid form, in gel-like form or in solid form, including preparations pressed into shape, particulates and powders, said receptacle- and/or packaging item being configured as a vial, a container, a bottle, a flask, an ampule, a sample tube, a cuvette, a pipette, a pipet tip, a syringe, a well plate, and the like.

19. The receptacle- and/or packaging item of any one of claims 17 or 18, configured as a medical package to enclose and store pharmaceuticals and medicine preparations.

10

20

Figure 1A

10

10-2 (M2)

10-1 (M1)

20

Figure 1B

10n

10n-1

10

10-2

10-1

20

Figure 1C

Figure 2

Figure 3A

Figure 3B

Figure 4

Europäisches
Patentamt

European
Patent Office

Office européen
des brevets

## EUROPEAN SEARCH REPORT

**Application Number**

EP 24 21 3483

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/263957 A1 (TAHA AHMAD [US] ET AL) 24 August 2023 (2023-08-24) * example 43, table Recipe A; paragraphs [0829], [0832], [0062] * ----- | 1,10,14, 17 | INV. C23C16/455 |
| X | KR 2023 0147271 A (IUCF SUNMOON UNIV [KR]) 23 October 2023 (2023-10-23) * paragraphs [0033], [0051], [0039], [0052], [0002], [0047], [0009], [0010], [0040] * ----- | 1-9, 11-13,17 | |
| X | US 2022/073256 A1 (FADEEV ANDREI GENNADYEVICH [US] ET AL) 10 March 2022 (2022-03-10) * paragraphs [0004], [0080], [0166]; claim 1; figure 1 * ----- | 15-19 | |

| | |
|---|---|
| | **TECHNICAL FIELDS SEARCHED (IPC)** |
| | A61J C23C |

The present search report has been drawn up for all claims

| Place of search | Date of completion of the search | Examiner |
|---|---|---|
| The Hague | 14 May 2025 | Schafranek, Robert |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 21 3483

This annex lists the patent family members relating to the patent documents cited in the above-mentioned European search report.
The members are as contained in the European Patent Office EDP file on
The European Patent Office is in no way liable for these particulars which are merely given for the purpose of information.

14-05-2025

| Patent document cited in search report | Publication date | Patent family member(s) | Publication date |
|---|---|---|---|
| US 2023263957 A1 | 24-08-2023 | CA 3184061 A1 | 30-12-2021 |
| | | EP 4168068 A1 | 26-04-2023 |
| | | JP 2023532450 A | 28-07-2023 |
| | | KR 20230056656 A | 27-04-2023 |
| | | US 2023263957 A1 | 24-08-2023 |
| KR 20230147271 A | 23-10-2023 | NONE | |
| US 2022073256 A1 | 10-03-2022 | CA 3191536 A1 | 10-03-2022 |
| | | CN 116075288 A | 05-05-2023 |
| | | EP 4208419 A2 | 12-07-2023 |
| | | JP 2023540736 A | 26-09-2023 |
| | | KR 20230062591 A | 09-05-2023 |
| | | US 2022073256 A1 | 10-03-2022 |
| | | WO 2022051645 A2 | 10-03-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8211235 B, Lindfors